Europäisches Patentamt

European Patent Office

Office européen des brevets

(11) Publication number : **0 368 210 B1**

(12) **EUROPEAN PATENT SPECIFICATION**

(45) Date of publication of patent specification :
**15.02.95 Bulletin 95/07**

(21) Application number : **89120517.1**

(22) Date of filing : **06.11.89**

(51) Int. Cl.⁶ : **H01L 39/24, C04B 35/00**

(54) **An oxide superconductor composition and a process for the production thereof.**

(30) Priority : **07.11.88 JP 281910/88**
**07.11.88 JP 281911/88**
**07.11.88 JP 281912/88**
**07.11.88 JP 281913/88**

(43) Date of publication of application :
**16.05.90 Bulletin 90/20**

(45) Publication of the grant of the patent :
**15.02.95 Bulletin 95/07**

(84) Designated Contracting States :
**DE FR GB**

(56) References cited :
**EP-A- 0 301 952**
**EP-A- 0 316 009**
**EP-A- 0 351 323**
**PHYSICA C, vol. 152, no. 4, 1st June 1988, pages 283-285, Elsevier Science Publichers B.V.(North-Holland Physics Publishing Division), Amsterdam, NL; A.K. BHATTACHARYA et al.: "High-temperature superconducting properties in the Y1-xAxBa2Cu3O7-deltasystem (A=In,Tl)"**

(73) Proprietor : **NEC CORPORATION**
**7-1, Shiba 5-chome**
**Minato-ku**
**Tokyo (JP)**

(72) Inventor : **Manako, Takashi c/o NEC Corporation**
**33-1, Shiba 5-chome**
**Minato-ku Tokyo (JP)**
Inventor : **Shimakawa, Yuichi c/o NEC Corporation**
**33-1, Shiba 5-chome**
**Minato-ku Tokyo (JP)**
Inventor : **Kubo, Yoshimi c/o NEC Corporation**
**33-1, Shiba 5-chome**
**Minato-ku Tokyo (JP)**

(74) Representative : **Pätzold, Herbert, Dr.-Ing.**
**Steubstrasse 10**
**D-82166 Gräfelfing (DE)**

## Description

The present invention relates to an cxide superconducting material for use in various superconductivity application apparatus and superconducting devices.

Up to the present, metal or alloy superconducting materials, intermetallic compound superconducting materials, etc. have already been put into practical use as superconducting materials. The superconducting materials are used for production of coils for superconducting magnets, electronics devices such as a Josephson device, etc. and are expected to realize applications particularly to a Superconducting Quantum Interference Device (=SQUID) and a precision measurement technique, utilizing the merits of high sensitivity, high precision and low noise properties of a Josephson junction, and also to an electronic computor, taking advantage of high speed responsibility and low electric power consumption properties of the Josephson junction.

It is desired that a critical temperature Tc at which the material changes its property to superconductive is as high as possible. Since an oxide superconductor of La-Ba-Cu-O system having a Tc around 30K was found, there are successively found oxide superconductors of Ba-Y-Cu-O system having a Tc around 90K, Bi-Sr-Ca-Cu-O system having a Tc around 110K, Tl-Ba-Ca-Cu-O system having a Tc around 120K, etc. These findings of the materials having Tc far exceeding a liquid nitrogen temperature are further enhancing expectations for use as practical materials.

For a superconducting substance, its Tc is an intrinsic value approximately always constant unless the substance is placed in a strong magnetic field. By varying the composition ratio of the elements constituting the superconducting substance, its Tc may change and often apparently lower owing to reduction of the superconducting transition volume fraction, which causes slower transition into the superconducting state.

If it is possible to obtain a substance which shows sharp transition into the superconducting state for its entire volume at any desired temperature, it becomes possible to develop many application fields such as use for a temperature sensor of such superconducting substance.

EP-A-0 351 323 falling within the terms of Article 54 (3) EPC discloses inter alia 92 K superconductor composition consisting of thallium barium calcium copper oxide in which a portion of calcium is replaced by yttrium.

An object of the present invention is therefore to present a superconductor which shows sharp transition into the superconducting state at Tc successively variable in accordance with its composition ratio and a process for the production thereof.

The present inventors have found through intensive and extensive researches that an oxide superconductor composition essentially consisting of a thallium barium calcium yttrium copper oxide wherein an atomic ratio of these elements being represented by the formula:

$$Tl_mBa_2(Ca_{1-x}Y_x)_{n-1}Cu_nO_{2+m+2n}$$

in which m is 1 or 2,

n is 2, 3 or 4 when m is 1 or n is 3 when m is 2, and

x is a number within the following ranges:

(a) $0.1 \leqq x \leqq 0.7$, when m = 1 and n = 2,

(b) $0.1 \leqq x \leqq 0.8$, when m = 1 and n = 3,

(c) $0.1 \leqq x \leqq 0.8$, when m = 1 and n = 4, and

(d) $0.1 \leqq x \leqq 0.4$, when m = 2 and n = 3,

shows after pressure molding and heat treatment, sharp transition at Tc and that its Tc is successively variable in accordance with the value of x; and also that the properties of the composition can be further improved by wrapping a pressure molded body with a gold foil at the heat treatment.

In effect, the present inventors have confirmed by experiments that compositions of the following table 1 show sharp transition into the superconducting state at temperatures shown in the table 1 and reveal at least 80% of the ideal a.c. susceptibility in the superconducting state.

2

Table 1

| No. | Composition | Tc (K) | Percentage of ideal a.c. susceptibility |
|---|---|---|---|
| (1) | $Tl\ Ba_2(Ca_{0.7}Y_{0.3})\ Cu_2O_7$ | 90 | almost 100 |
| (2) | $Tl\ Ba_2(Ca_{0.4}Y_{0.6})\ Cu_2O_7$ | 40 | almost 100 |
| (3) | $Tl\ Ba_2(Ca_{0.7}Y_{0.3})_2Cu_3O_9$ | 90 | not less than 80 |
| (4) | $Tl\ Ba_2(Ca_{0.4}Y_{0.6})_2Cu_3O_9$ | 40 | not less than 80 |
| (5) | $Tl\ Ba_2(Ca_{0.9}Y_{0.1})_3Cu_4O_{11}$ | 114 | about 80 |
| (6) | $Tl_2Ba_2(Ca_{0.9}Y_{0.1})_2Cu_3O_{10}$ | 85 | not less than 80 |
| (7) | $Tl_2Ba_2(Ca_{0.7}Y_{0.3})_2Cu_3O_{10}$ | 30 | not less than 80 |

By the way, it is known that Tl series superconductors have presently highest Tc values. The main consitutional element Tl however is strongly poisonous and so its handling is not easy. For example, in a superconducting composition $Tl_2Ba_2Ca_2Cu_3O_{10}$, which is known as having Tc of 120K, about 40% by weight of the total weight are occupied with Tl and so extreme care must be taken to produce it. If it is possible to reduce the Tl content without lowering Tc, it becomes possible to lessen the danger from the production working and also to save the use amount of the rare element Tl.

The superconductor composition of the present invention wherein m=1 and n=4 includes only about half amount of Tl compared with the above known composition and so is very advantageous in this respect. In effect, the composition (5) of the above table 1 shows sharp transition into the superconducting state at 114K, and this Tc becomes lower as the value of x [=0.1 in (5)] is increased, but without damaging the sharpness of the transition. The Tl content of such composition (5) is only 19% of the total weight.

The present invention will be explained below further in detail with respect to its some embodiments shown as working examples.

Example 1

As for starting materials, thallium oxide ($Tl_2O_3$), barium oxide (BaO), calcium oxide (CaO), yttrium oxide

(Y$_2$O$_3$) and cupric oxide (CuO), respectively of 99% or more purity were used. These materials were taken up and weighed to show each of the composition ratios as shown in the following table 2, well mixed in a mortar and then pressed into a pressed body in a size of 5mm x 10mm x 1mm. This pressed body was wrapped with a gold foil and sintered at 850 - 910°C for 1 - 10 hours in an oxygen atmosphere.

Then measurements were made on the samples obtained from the composition ratios and under various conditions as to their resistivities and the a.c. magnetic susceptibility in order to evaluate their superconductivity properties.

The resistivity was measured by using a dc four probe method. The electrical contacts were made by using gold electrodes sputtered on the sample surface and the copper lead wires plated with tin.

The a.c. magnetic susceptibility measurement was carried out by determining any change of inductance L of a coil wherein a sample was placed, and calculating on the basis of $\Delta$L at 4.2K of lead of the same volume and the same shape as equal to 100.

The resitivity measurement was made within a temperature range of from a room temperature to a temperature showing zero resistivity and the magnetic susceptibility measurement was made within a temperature range of from a room temperature to 4.2K.

In the table 2, the critical temperature Tc at which the resistivity becomes zero and the a.c. magnetic susceptibility at 4.2K as measured on the samples are shown along with the composition ratios.

## Table 2

| Sample No. | Composition | x value | Tc (K) | Percentage of ideal a.c. susceptibility Signal |
|---|---|---|---|---|
| 1 | $TlBa_2(Ca_{0.9}Y_{0.1})Cu_2O_7$ | 0.1 | 101 | 91 |
| 2 | $TlBa_2(Ca_{0.8}Y_{0.2})Cu_2O_7$ | 0.2 | 90 | 93 |
| 3 | $TlBa_2(Ca_{0.5}Y_{0.5})Cu_2O_7$ | 0.5 | 88 | 95 |
| 4 | $TlBa_2(Ca_{0.4}Y_{0.6})Cu_2O_7$ | 0.6 | 60 | 99 |
| 5 | $TlBa_2(Ca_{0.3}Y_{0.7})Cu_2O_7$ | 0.7 | 40 | 100 |

As shown in the above, the compositions according to the present invention have Tc values variable in accordance with the change of x values and at the same time show sharp transition into the superconducting state.

It was also found that in case the samples were sintered without being wrapped with gold foil, the composition ratios were changed owing to the loss of Tl in the course of sintering, and as the results, the a.c. susceptibility were somewhat reduced.

It is to be noted that if x was made less than 0.1, the superconducting properties were almost not variable and so such x value is not suitable for the purpose of the present invention. If x was made larger than 0.7, no superconductivity was shown from the room temperature to 4.2K and so such x value is not suitable for practical use.

Further, the sintering conditions should desirably be within ranges of 850 - 910°C and 1 - 10 hours in an oxygen atmosphere in order to obtain excellent sintered bodies. The temperature lower than 850°C is insufficient for proceeding the reaction to obtain excellent superconducting properties and the temperature exceeding 910°C causes decomposition and thus lowers the a.c. susceptibility.

Example 2

The procedures same as the above Example 1 were repeated, excepting that the composition ratios employed were those shown in the following table 3 and the sintering temperature employed was 870-910°C. The results were as follows:

Table 3

| Sample No. | Composition | x value | Tc (K) | Percentage of ideal a.c. susceptibility Signal |
|---|---|---|---|---|
| 1 | $TlBa_2(Ca_{0.9}Y_{0.1})_2Cu_3O_9$ | 0.1 | 116 | 81 |
| 2 | $TlBa_2(Ca_{0.8}Y_{0.2})_2Cu_3O_9$ | 0.2 | 95 | 83 |
| 3 | $TlBa_2(Ca_{0.5}Y_{0.5})_2Cu_3O_9$ | 0.5 | 70 | 83 |
| 4 | $TlBa_2(Ca_{0.4}Y_{0.6})_2Cu_3O_9$ | 0.6 | 40 | 85 |
| 5 | $TlBa_2(Ca_{0.2}Y_{0.8})_2Cu_3O_9$ | 0.8 | 13 | 88 |

As shown in the above, the compositions according to the present invention have Tc values variable in accordance with the change of x values and at the same time show sharp transition into the superconducting state.

It was also found that in case the samples were sintered without being wrapped with gold foil, the composition ratios were changed owing to the loss of Tl in the course of sintering, and as the results, the a.c. susceptibility were somewhat reduced.

It is to be noted that if x was made less than 0.1, the superconducting properties were almost not variable and so such x value is not suitable for the purpose of the present invention. If x was made larger than 0.8, no superconductivity was shown from the room temperature to 4.2K and so such x value is not suitable for practical use.

Further, the sintering conditions should desirably be within ranges of 870 - 910 °C and 1 - 10 hours in an oxygen atmosphere in order to obtain excellent sintered bodies. The temperature lower than 870 °C causes production of a mixture with $TlBa_2(Ca_{1-x}Y_x)Cu_2O_7$ having a shorter crystal period and so the a.c. susceptibility showing Tc of not lower than 100K is reduced. The temperature exceeding 910 °C causes decomposition and thus lowers the a.c. susceptibility.

Example 3

The procedure same as the above Example 1 were repeated, excepting that the composition ratios employed were those shown in the following table 4 and the sintering temperature employed was 875-915 °C. The results were as follows:

Table 4

| Sample No. | Composition | x value | Tc (K) | Percentage of ideal a.c. susceptibility Signal |
|---|---|---|---|---|
| 1 | $TlBa_2(Ca_{0.9}Y_{0.1})_3Cu_4O_{11}$ | 0.1 | 114 | 75 |
| 2 | $TlBa_2(Ca_{0.8}Y_{0.2})_3Cu_4O_{11}$ | 0.2 | 93 | 75 |
| 3 | $TlBa_2(Ca_{0.5}Y_{0.5})_3Cu_4O_{11}$ | 0.5 | 60 | 77 |
| 4 | $TlBa_2(Ca_{0.4}Y_{0.6})_3Cu_4O_{11}$ | 0.6 | 20 | 79 |
| 5 | $TlBa_2(Ca_{0.2}Y_{0.8})_3Cu_4O_{11}$ | 0.8 | 10 | 82 |

As shown in the above, the compositions according to the present invention have Tc values variable in accordance with the change of x values and at the same time show sharp transition into the superconducting state.

It was also found that in case the samples were sintered without being wrapped with gold foil, the composition ratios were changed owing to the loss of Tl in the course of sintering, and as the results, the a.c. susceptibility were somewhat reduced.

It is to be noted that if x was made less than 0.1, the superconducting properties were almost not variable and so such x value is not suitable for the purpose of the present invention. If x was made larger than 0.8, no superconductivity was shown from the room temperature to 4.2K and so such x value is not suitable for practical use.

Further, the sintering conditions should desirably be within ranges of 875 - 915 °C and 1 - 10 hours in an oxygen atmosphere in order to obtain excellent sintered bodies. The temperature lower than 875 °C causes production of a mixture with $TlBa_2(Ca_{1-x}Y_x)Cu_2O_7$ and $TlBa_2(Ca_{1-x}Y_x)_2Cu_3O_9$ having shorter crystal periods and so the a.c. susceptibility volume fraction showing Tc of not lower than 100K is reduced. The temperature exceeding 910 °C causes decomposition and thus lowers the a.c. susceptibility.

Example 4

The procedures same as the above Example 1 were repeated, excepting that the composition ratios employed were those shown in the following table 5 and the sintering temperature employed was 870-910 °C. The results were as follows:

Table 5

| Sample No. | Composition | x value | Tc (K) | Percentage of ideal a.c. susceptibility Signal |
|---|---|---|---|---|
| 1 | $Tl_2Ba_2(Ca_{0.9}Y_{0.1})_2Cu_3O_{10}$ | 1.1 | 120 | 88 |
| 2 | $Tl_2Ba_2(Ca_{0.8}Y_{0.2})_2Cu_3O_{10}$ | 1.2 | 59 | 83 |
| 3 | $Tl_2Ba_2(Ca_{0.6}Y_{0.4})_2Cu_3O_{10}$ | 1.4 | 32 | 78 |

As shown in the above, the compositions according to the present invention have Tc values variable in accordance with the change of x values and at the same time show sharp transition into the superconducting state.

It was also found that in case the samples were sintered without being wrapped with gold foil, the composition ratios were changed owing to the loss of Tl in the course of sintering, and as the results, the a.c. susceptibility were somewhat reduced.

It is to be noted that if x was made less than 0.1, the superconducting properties were almost not variable and so such x value is not suitable for the purpose of the present invention. If x was made larger than 0.4, compositions having different crystal structures of $TlBa_2(Ca_{1-x}Y_x)_2Cu_3O_9$, etc. will tend to co-exist and badly affect the controllability of Tc and so such x value is not suitable for practical use.

Further, the sintering conditions should desirably be within ranges of 870 - 910 °C and 1 - 10 hours in an oxygen atmosphere in order to obtain excellent sintered bodies. The temperature lower than 870 °C is insufficient for proceeding the reaction to obtain excellent superconducting properties and the temperature exceeding 910 °C causes decomposition and thus lowers the a.c. susceptibility.

Thus the present invention provides a very useful superconducting material, Tc of which is controllable to successively vary in accordance with the value of x and also the transition into the superconducting state of which is very sharp.

## Claims

1. An oxide superconductor composition essentially consisting of a thallium barium calcium yttrium copper oxide wherein an atomic ratio of these elements being represented by the formula:

$$Tl_mBa_2(Ca_{1-x}Y_x)_{n-1}Cu_nO_{2+m+2n}$$

in which m is 1 or 2,

n is 2, 3 or 4 when m is 1 or n is 3 when m is 2, and

x is a number within the following ranges:

(a) $0.1 \leqq x \leqq 0.7$, when m = 1 and n = 2,

(b) $0.1 \leqq x \leqq 0.8$, when m = 1 and n = 3,

(c) $0.1 \leqq x \leqq 0.8$, when m = 1 and n = 4, and

(d) $0.1 \leqq x \leqq 0.4$, when m = 2 and n = 3.

2. A process for the production of an oxide superconductor composition essentially consisting of a thallium barium calcium yttrium copper oxide wherein powders of thallium oxide ($Tl_2O_3$), barium oxide (BaO), calcium oxide (CaO), yttrium oxide ($Y_2O_3$) and cupric oxide (CuO) are mixed together in a ratio of giving an atomic ratio of these elements being represented by the formula:

$$Tl_mBa_2(Ca_{1-x}Y_x)_{n-1}Cu_nO_{2+m+2n}$$

in which m is 1 or 2,

n is 2, 3 or 4 when m is 1 or n is 3 when m is 2, and

x is a number within the following ranges:

(a) $0.1 \leqq x \leqq 0.7$, when m = 1 and n = 2,

(b) $0.1 \leqq x \leqq 0.8$, when m = 1 and n = 3,

(c) $0.1 \leqq x \leqq 0.8$, when m = 1 and n = 4, and

(d) $0.1 \leqq x \leqq 0.4$, when m = 2 and n = 3,

pressure molded and subjected to a heat treatment.

3. The process according to claim 2, wherein said powders as mixed and pressure molded are wrapped with a gold foil and then subjected to said heat treatment.

4. The process according to claim 2, wherein as said heat treatment, sintering is made at a temperature in a range of 850 - 910 °C, when m = 1 and n = 2.

5. The process according to claim 2, wherein as said heat treatment, sintering is made at a temperature in a range of 870 - 910 °C, when m = 1 and n = 3.

6. The process according to claim 2, wherein as said heat treatment, sintering is made at a temperature in a range of 875 - 915 °C, when m = 1 and n = 4.

7. The process according to claim 2, wherein as said heat treatment, sintering is made at a temperature in a range of 870 - 910 °C, when m = 2 and n = 3.

## Patentansprüche

1. Oxidsupraleiter-Zusammensetzung, die im wesentlichen aus einem Thallium-Barium-Calcium-Yttrium-Kupfer-Oxid besteht, bei welcher das Atomverhältnis dieser Elemente durch folgende Formel dargestellt wird:

$$Tl_mBa_2(Ca_{1-x}Y_x)_{n-1}Cu_nO_{2+m+2n}$$

wobei **m** 1 oder 2 ist,

**n** 2, 3 oder 4 ist, wenn **m** 1 ist, oder **n** 3 ist, wenn **m** 2 ist, und

**x** eine Zahl innerhalb der folgenden Bereiche ist:

(a) $0,1 \leqq x \leqq 0.7$ wenn **m** = 1 und **n** = 2

(b) $0.1 \leqq x \leqq 0.8$ wenn **m** = 1 und **n** = 3

(c) $0.1 \leqq x \leqq 0.8$ wenn **m** = 1 und **n** = 4, und

(d) $0.1 \leqq x \leqq 0.4$ wenn **m** = 2 und **n** = 3.

2. Verfahren zur Herstellung einer im wesentlichen aus einer aus Thallium-Barium-Calcium-Yttrium-Kupfer-Oxid bestehenden Oxidsupraleiter-Zusammensetzung, bei welchem Thalliumoxid ($Tl_2O_3$), Bariumoxid

(BaO), Calciumoxid (CaO), Yttriumoxid ($Y_2O_3$) und Kuper(II)-oxid, jeweils in Pulverform, in einem solchen Verhältnis miteinander vermischt werden, daß sich ein Atomverhältnis dieser Elemente ergibt, das durch die folgende Formel dargestellt wird:

$$Tl_mBa_2(Ca_{1-x}Y_x)_{n-1}Cu_nO_{2+m+2n}$$

wobei **m** 1 oder 2 ist,

**n** 2, 3 oder 4 ist, wenn **m** 1 ist, oder **n** 3 ist, wenn **m** 2 ist, und

**x** eine Zahl innerhalb der folgenden Bereiche ist:

    (a) $0{,}1 \leqq \mathbf{x} \leqq 0.7$ wenn **m** = 1 und **n** = 2

    (b) $0.1 \leqq \mathbf{x} \leqq 0.8$ wenn **m** = 1 und **n** = 3

    (c) $0.1 \leqq \mathbf{x} \leqq 0.8$ wenn **m** = 1 und **n** = 4, und

    (d) $0.1 \leqq \mathbf{x} \leqq 0.4$ wenn **m** = 2 und **n** = 3,

        die unter Druck geformt und wärmebehandelt wird.

**3.** Verfahren nach Anspruch 2, bei welchem Pulver nach Vermischung und Formung unter Druck mit einer Goldfölie umhüllt und anschließend der Wärmebehandlung unterzogen werden.

**4.** Verfahren nach Anspruch 2, bei welchem als Wärmebehandlung ein Sintervorgang bei einer Temperatur im Bereich zwischen 850 und 910 °C abläuft, wenn **m** = 1 und **n** = 2 ist.

**5.** Verfahren nach Anspruch 2, bei welchem als Wärmebehandlung ein Sintervorgang bei einer Temperatur im Bereich zwischen 870 und 910 °C abläuft, wenn **m** = 1 und **n** = 3 ist.

**6.** Verfahren nach Anspruch 2, bei welchem als Wärmebehandlung ein Sintervorgang bei einer Temperatur im Bereich zwischen 875 und 915 °C abläuft, wenn **m** = 1 und **n** = 4 ist.

**7.** Verfahren nach Anspruch 2, bei welchem als Wärmebehandlung ein Sintervorgang bei einer Temperatur im Bereich zwischen 870 und 910 °C abläuft, wenn **m** = 2 und **n** = 3.

## Revendications

**1.** Composition de supraconducteur en oxyde, constituée essentiellement d'un oxyde de thallium-baryumcalcium-yttrium-cuivre, dans laquelle le rapport atomique de ces éléments est représenté par la formule :

$$Tl_mBa_2(Ca_{1-x}Y_x)_{n-1}Cu_nO_{2+m+2n}$$

dans laquelle m est 1 ou 2,

n est 2, 3 ou 4 lorsque m est 1, ou n est 3 lorsque m est 2, et

x est un nombre compris dans les plages suivantes :

    (a) $0{,}1 \leqq x \leqq 0{,}7$ lorsque m = 1 et n = 2,

    (b) $0{,}1 \leqq x \leqq 0{,}8$ lorsque m = 1 et n = 3,

    (c) $0{,}1 \leqq x \leqq 0{,}8$ lorsque m = 1 et n = 4, et

    (d) $0{,}1 \leqq x \leqq 0{,}4$ lorsque m = 2 et n = 3,

**2.** Procédé pour la fabrication d'une composition de supraconducteur en oxyde, constituée essentiellement d'un oxyde de thallium-barium-calciumyttrium-cuivre, dans lequel des poudres d'oxyde de thallium ($Tl_2O_3$), d'oxyde de baryum (BaO), d'oxyde de calcium (CaO), d'oxyde d'yttrium ($Y_2O_3$) et d'oxyde cuivrique (CuO) sont mélangées ensemble dans un rapport donnant un rapport atomique de ces éléments représenté par la formule :

$$Tl_mBa_2(Ca_{1-x}Y_x)_{n-1}Cu_nO_{2+m+2n}$$

dans laquelle m est 1 ou 2,

n est 2, 3 ou 4 lorsque m est 1, ou n est 3 lorsque m est 2, et

x est un nombre compris dans les plages suivantes :

    (a) $0{,}1 \leqq x \leqq 0{,}7$ lorsque m = 1 et n = 2,

    (b) $0{,}1 \leqq x \leqq 0{,}8$ lorsque m = 1 et n = 3,

    (c) $0{,}1 \leqq x \leqq 0{,}8$ lorsque m = 1 et n = 4, et

    (d) $0{,}1 \leqq x \leqq 0{,}4$ lorsque m = 2 et n = 3,

sont moulées sous pression et soumises à un traitement thermique.

**3.** Procédé selon la revendication 2, dans lequel lesdites poudres telles que mélangées et moulées sous pression sont enroulées dans un clinquant d'or et soumises ensuite audit traitement thermique.

4.  Procédé selon la revendication 2, dans lequel, comme dit traitement thermique, un frittage est exécuté à une température comprise dans la gamme de 850-910°C, lorsque m = 1 et n = 2.

5.  Procédé selon la revendication 2, dans lequel, comme dit traitement thermique, un frittage est exécuté à une température comprise dans la gamme de 870-910°C, lorsque m = 1 et n = 3.

6.  Procédé selon la revendication 2, dans lequel, comme dit traitement thermique, un frittage est exécuté à une température comprise dans la gamme de 875-915°C, lorsque m = 1 et n = 4.

7.  Procédé selon la revendication 2, dans lequel, comme dit traitement thermique, un frittage est exécuté à une température comprise dans la gamme de 870-910°C, lorsque m = 2 et n = 3.